# EUROPEAN PATENT APPLICATION

(11) **EP 0 997 739 A2**
(43) Date of publication of application: **03.05.2000**
(21) Application number: 99120025.4
(22) Date of filing: 18.10.1999
(51) Int. Cl.: G01R 31/02

(54) **Apparatus for testing of single leads**

(30) Priority: 27.10.1998 DE 19849526
(71) Applicant: FRAMATOME CONNECTORS INTERNATIONAL, 92400 Courbevoie (FR)
(72) Inventor: Jossifidis, Ilias, 90461 Nürnberg (DE)
(74) Representative: Beetz & Partner Patentanwälte

(57) **Abstract**

An apparatus for the testing of single leads is disclosed, with a base plate (1) with a longitudinal slot (3) along its entire length, with a counter plate (4), guide components (2) which are fastened to one of the two plates (1 and 4) and which guide the other plate in such a way that the counter plate (4) can be moved parallel to the base plate (1), at least one pair of contact studs (6) where one set of ends (7) of the contact studs (6) is connected to the counter plate (4), that the contact studs (6) are rotating and pass through the longitudinal slot (3), at least one elastic component (11 and 12) which gathers together the free ends (8) of the contact studs (6) so that when the apparatus is in the "closed" position, the single leads (14) are clamped between the pair of contact studs and of at least one separating device (9 and 10) which releases the single leads when in the "open" position.

## Description

The present invention concerns an apparatus or the testing of single leads according to the teaching of the Claim 1.

Such a connection can be used anywhere where cable looms with several single leads exist. A particular field of utilisation of this device is first and foremost represented by the automotive industry which most importantly tests new cable looms of passenger vehicles. In this case the apparatus is an exchangeable test module of of modularly-constructed system of testing cable looms.

The German Specification G 87 13 233 discloses an apparatus for the construction and testing of cable looms consisting of single leads.

In this apparatus, the ends of the cable loom must be gathered together in a plug and are then introduced into the corresponding sockets of the apparatus and temporarily held there. It is a particular drawback of this apparatus that the ends of the cable loom must be provided with a plug in order that the single leads of the cable loom should be able to be tested. This therefore makes it necessary that a separate plug should be used for every end of the cable loom and thus automatically calls for the presence of the counter plug. If a fault occurs, it is not possible to ascertain whether the fault is due to the plug or to incorrect laying of the cable.

It is the task of the present invention to provide an apparatus for the testing of single leads which is independent of possible faults of the plug connectors of a cable loom.

This task is solved by means of the characteristics given in the relevant part of the independent Claim.

An apparatus for the testing of single leads comprises a base plate in which a slot has been cut, a counter plate and guide components which are fastened to one of the two plates and guide the other plate in such a way that the counter plate can be moved in a path parallel to the base plate. Furthermore, the apparatus has at least two contact studs where one set of ends of the contact studs are joined to the counter plate in such a way that the contact studs can be rotated and pass through the longitudinal slot. In addition, the apparatus comprises at least one elastic component which brings the free ends of the contact studs together in such a way that in the "closed" position of the apparatus, the single lead is clamped between the two contact studs and at least one separation device, which releases the single lead when the apparatus moves into the "open" position.

The plates are preferably moved together by means of a driving device, preferably one such as a pneumatic cylinder or an electromechanical actuator.

The guide elements preferably consist of at least two guide rods which pass through holes drilled in the counter plate and are fastened to the base plate. This ensures that the counter plate can be moved parallel to the base plate and the contact studs can either be forced deeper into the counter plate or pulled out of the slot, depending on the direction of movement of the counter plate. Furthermore, the cables are not liable to twisting or kinking during testing.

In this apparatus, the fact that in order to test the cable loom, the ends of the cable looms need not necessarily be fitted with a plug, is particularly advantageous. This makes it possible to recognise whether a single lead has been positioned correctly within the cable loom and whether current is able to pass. This apparatus also makes possible to check a cable loom fitted with plugs, by simply cutting off the plug and isolating the individual leads of the cable and connecting them to the apparatus. In this way, any defects of a plug or of the plug connector can be prevented.

In the manufacturing of a cable loom, it is not necessarily desirable that all ends should be fitted with plugs so that it is also possible to test these ends.

Various embodiment examples of the invention are explained more fully in the drawings.

The said drawings show :
- Fig 1: a diagonal view of an apparatus according to the invention which is in the "closed" position
- Fig 2: a cross-section along Level A of the apparatus described in Fig 1
- Fig 3: a plan view of a first embodiment of the device
- Fig 4: a plan view of a second embodiment of the device in the "closed" position ; and
- Fig 5: a plan view of the second embodiment of the device in the "open" position

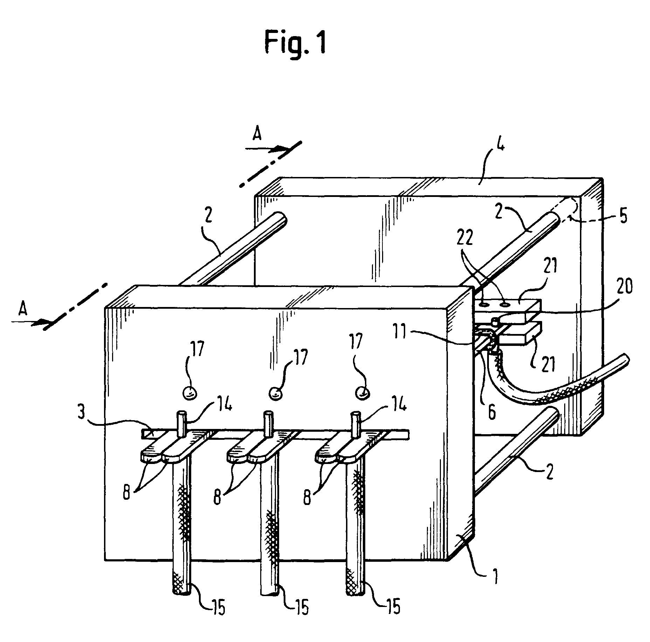

As can be seen from Fig 1, the apparatus comprises a base plate 1 with a length wise slot 3 and three pilot lights 17, a counter plate 4 with four drilled holes 5, four guide rods 2 which are fixed to the base plate 1 at one end and whose other end passes through the drilled holes 5. This ensures that the plates are arranged parallel to one another and that they can be moved towards one another. In this space formed and enclosed between the two plates, there are, *inter al,* the two retaining blocks 21 which are fastened to the counter plate so that a gap is formed between the said retaining blocks 21. In this gap are arranged the ends 7 of the contact studs 6.

The contact studs are clamped there by means of the axle 22 so that they are able to rotate about the latter.

In the immediate vicinity of the retaining blocks 21, the contact studs carry contact connectors 20 to which the cables are electrically connected. These cables are led to the outside by means of a connector device which is not shown and not described in more detailed.

The contact studs are held together in pairs by means of a rubber ring 21. It should be noted that the gap between the retaining blocks is flush with the slot 3 of the base plate, so that the free ends 8 of the contact studs 6 are forced into the slot without mechanical stress.

Since the contact studs are firmly fastened to the counter plate 4, the free ends of the contact studs project from the space, depending on the position of the counter plate 4. It can be seen from Fig 1 that the counter plate has been moved towards the base plate 1, so far that the free ends can be seen and correspondingly clamp and make electrical contact with, the single lead 14 of a cable 15.

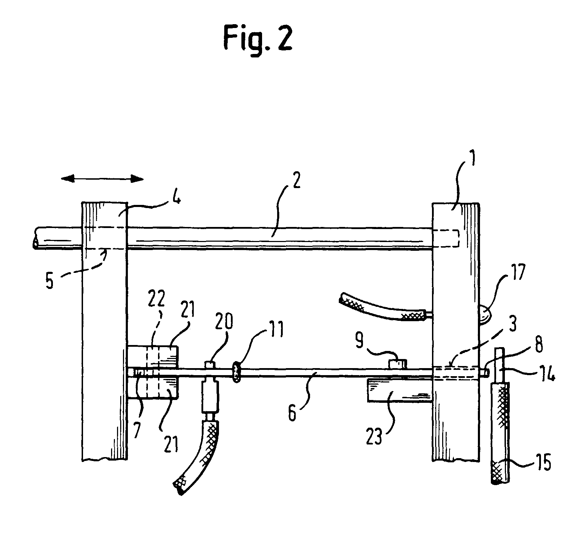

Fig 2 shows a slot along level A of the apparatus, the apparatus being in the "open" position, which means that the single leads are not clamped by the contact studs 6. The said Fig 2 shows that the counter plate 4 is sufficiently distant from base plate 1 and that the free ends 8 of the contact studs 6 project only slightly from the slot 3. Furthermore, a separating device can be seen in the empty space, which in this embodiment consists of a retaining block 23 with a pin 9 fastened to the base plate 1. It can also clearly be seen that the contact studs are arranged parallel to the direction of movement.

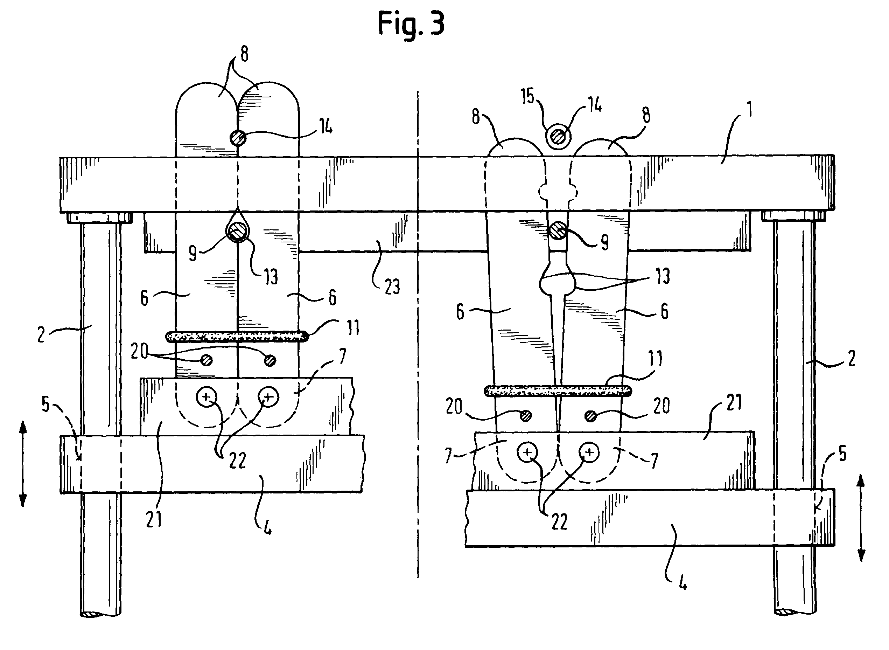

The manner of functioning of the clamping of this apparatus will be explained more fully in Figs 3 or 4 and 5 by means of two embodiments.

Fig 3 shows a plan view of the first embodiment of the apparatus. Fig 3 is divided into a left hand area and a right hand area. The left hand area of Fig 3 shows the apparatus in the "closed" position, that is to say, the free ends of the contact studs clamp and make contact with the single leads. The ends of the single leads need not necessarily be insulated, the ends of these single leads can also be freed from their insulating sheath. If it is desired to break off this connection, the counter plate 4 is moved downwards (cf Fig 3) and the contact studs 6 are simultaneously guided rearwards and since the pin 9 which is located in the recess 13 needs a corresponding amount of room and acts against the elastic forces of the rubber ring 11 on the edges of the contact studs, with the one set of the ends 7 being rotating about the axles 14 so that only the set of free ends 8 of the contact studs separate and release the single lead 14. In this way, the apparatus finally reaches the "open" position which is shown on the right hand side of Fig 3.

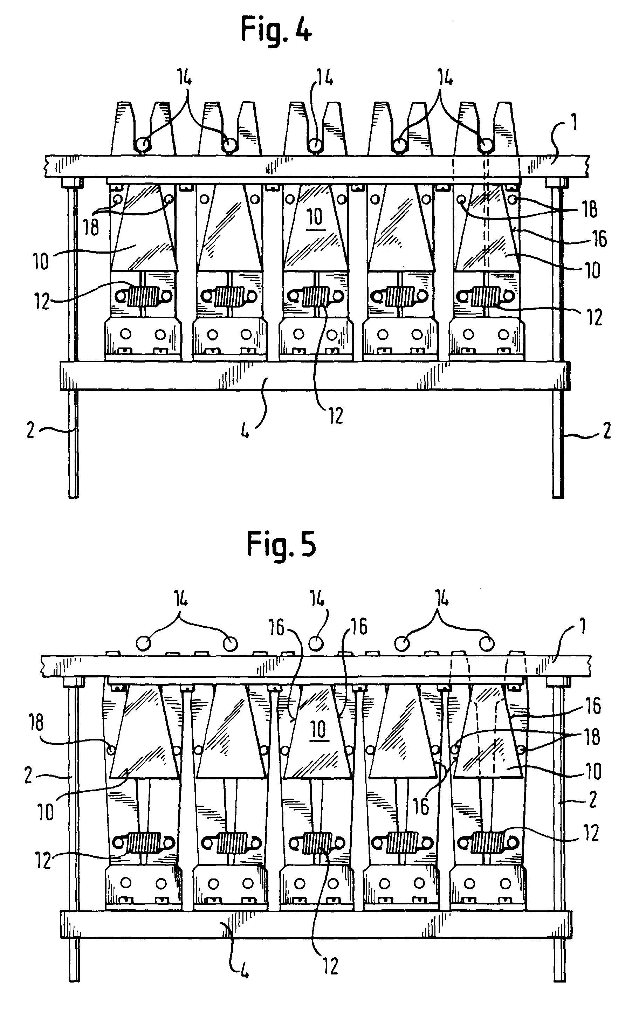

Figs 4 and 5 also show a plan view of the apparatus, but in a second embodiment. Fig 4 shows the apparatus in its "closed" position and Fig 5 in its "open" position. In this embodiment, the elastic components are present in the form of extension springs 22, making it necessary for each contact stud to have an additional pin to which one end of the extension spring 12 is fastened. With the system which has just been described, the same action results as the action of the rubber ring 11 in the other embodiment.

Furthermore, the separating device of the first embodiment differs in that only one wedge 10 per pair of contact studs is fastened to the base plate 1. This wedge is arranged vertically to the base plate 1 and parallel to the contact studs 6. The narrower end of this trapezoidal wedge is fastened to the base plate 1, so that the wedge becomes wider in the direction of the counter plate 4. The form of wedge is chosen to be such that at the narrower end of the wedge both to the right and the left of it, enough space is available to allow the contact studs to be vertical to the pins 18 so that, as Fig 4 shows, when the apparatus is in the "closed position", the pins do not touch the edges of the wedge, Preferably, the wider end of the wedge has the same width as a pair of contact studs.

If the counter plate is now also moved downwards, the contact studs move out of the slot. The pins 18 reach the edge of the wedge and as soon as the counter plate is moved, the edges of the wedge 10 lean against the pins 18, since the wedge becomes wider in the direction of the movement. The wedge therefore presses against the pins 18 which are connected to the contact studs, so that the free ends 8 of the contact studs 6 are forced apart and the clamped single leads are released and finally are in the "closed" position, as shown in Fig 5.

It should be noted that the ends of the contact studs 10 in this embodiment are inward-slanting and become narrower, so that a uniformly wide space forms between the contact studs in the "closed" position. Instead of using two retaining blocks 21, two L-shaped corner components are used to fasten the contact studs.

## Claims

1. An apparatus for testing single leads with
- a base plate (1) with a longitudinal slot (3) along its entire length
- a counter plate (4)
- guide components (2) which are fastened to one of the plates (1 and 4) and which guide the other plate in such a way that the counter plate (4) can be moved parallel to the base plate (1)
- at least one pair of contact studs (6) where one set of ends (7) is connected to the counter plate (4) in such a way that the contact studs (6) are rotating and pass through the longitudinal slot (3)
- at least one elastic component (11 and 12) which gathers the free ends (8) of the contact studs (6), so that the single leads (14) are clamped between the pair of contact studs in the "closed" position of the device and
- at least one separation device (9 and 10) which releases the single leads in the "open" position of the device.

2. Apparatus according to Claim 1 characterised by the fact that the elastic element is a rubber ring (11) which is arranged round the paid of contact studs.

3. Apparatus according to Claim 1 characterised by the fact that the elastic component is an extension spring, one end of which is fastened to one of the contact studs and the other end to the other contact stud.

4. Apparatus according to one of the preceding Claims characterised by the fact that the separating device has a separating pin (9) fastened to the base plate (1) and two recesses (13) in the contact studs (6) so that the separating pin (9) is in the "closed" position between the contact studs (6) in the recesses (13).

5. Apparatus according to Claims 1 to 3 characterised by the fact that the separation device has a wedge (10) connected with the base plate (1) and two pins (18) where a pin (18) is arranged on each contact stud in such a way that in the process of transition from one position to the other the pins (18) slide along the outside edges (16) of the wedge (10).

6. Apparatus according to one of the preceding Claims characterised by the fact that the Ends (7 and 8) of the contact studs (6) are semicircular in shape.

7. Apparatus according to one of the preceding Claims characterised by the fact that the free ends (8) of the contact studs (6) are narrower, so that an intermediate space (19) of uniform width forms in the "open" position between the contact studs.

8. Apparatus according to one of the preceding Claims characterised by five pairs of contact studs (6) for the simultaneous testing of five single leads (14).

9. Apparatus according to one of the preceding Claims characterised by at least one pilot light (17) which indicates that current is passing through the clamped single leads (14).

10. Apparatus according to one of the preceding Claims characterised by the fact that the plates (1 and 4) can be moved towards one another by means of a drive device, in particular one such as a pneumatic cylinder or an electromechanical actuator.

11. Apparatus according to one of the preceding Claims characterised by the fact that the guide components consist of at least two guide rods (2) which pass through the drilled holes (5) in the counter plate and are fastened to the base plate (1).
